# EUROPEAN PATENT APPLICATION

(11) **EP 4 307 327 A1**
(43) Date of publication of application: **17.01.2024**
(21) Application number: 22767023.9
(22) Date of filing: 04.03.2022
(51) Int. Cl.: H01F 10/32, H01L 43/08, G01R 33/09

(54) **MAGNETIC SENSOR AND METHOD OF MANUFACTURING MAGNETIC SENSOR**

(30) Priority: 12.03.2021 JP 2021040503
(71) Applicant: Panasonic Holdings Corporation, Osaka 571-8501 (JP)
(72) Inventor: KOHARA, Naoki, Kadoma-shi, Osaka 571-0057 (JP); ONAKA, Kazuhiro, Kadoma-shi, Osaka 571-0057 (JP); NAKATANI, Tomoya, Tsukuba-shi, Ibaraki 350-0047 (JP); KULKARNI, Prabhanjan Dilip, Tsukuba-shi, Ibaraki 350-0047 (JP)
(74) Representative: Novagraaf International SA
(86) International application number: PCT/JP2022/009380
(87) International publication number: WO 2022/191065

(57) **Abstract**

An object of the present disclosure is to increase the output of a magnetic sensor. A magnetic sensor (1) includes a ceramic substrate (2), a GMR layer (5), and an undercoat layer (4). The ceramic substrate (2) includes a substrate body (20) and a glazing layer (3). The substrate body (20) contains a ceramic as a material thereof. The glazing layer (3) is formed on a surface of the substrate body (20). The GMR layer (5) has a multilayer structure of a plurality of magnetic layers (6) and a plurality of non-magnetic layers (7). The undercoat layer (4) is formed between the glazing layer (3) and the GMR layer (5). The undercoat layer (4) contains a BCC solid solution.

## Description

### Technical Field

The present disclosure generally relates to a magnetic sensor and a method of manufacturing the magnetic sensor, and more particularly relates to a magnetic sensor including a GMR layer and a method of manufacturing such a magnetic sensor.

### Background Art

Patent Literature 1 discloses a magnetoresistive (MR) sensor (magnetic sensor) including an MR stripe containing NiFe and a first spacer layer (undercoat layer) containing an NiFeCr alloy and coupled to the MR stripe. The composition ratio of the first spacer layer is selected to optimize the MR coefficient and thermal stability of the MR stripe.

### Citation List

### Patent Literature

Patent Literature 1: US 5731936 A

### Summary of Invention

An object of the present disclosure is to increase the output of a magnetic sensor.

A magnetic sensor according to an aspect of the present disclosure includes a ceramic substrate, a GMR layer, and an undercoat layer. The ceramic substrate includes a substrate body and a glazing layer. The substrate body contains a ceramic as a material thereof. The glazing layer is formed on a surface of the substrate body. The GMR layer has a multilayer structure of a plurality of magnetic layers and a plurality of non-magnetic layers. The undercoat layer is formed between the glazing layer and the GMR layer. The undercoat layer contains a BCC solid solution.

A method of manufacturing a magnetic sensor according to another aspect of the present disclosure includes the steps of: forming a glazing layer on a surface of a substrate body containing a ceramic as a material thereof; forming an undercoat layer, containing a BCC solid solution, on a surface of the glazing layer; and forming a GMR layer, having a multilayer structure of a plurality of magnetic layers and a plurality of non-magnetic layers, on a surface of the undercoat layer.

### Brief Description of Drawings

FIG. 1 is a side cross-sectional view of a magnetic sensor according to an exemplary embodiment;
FIG. 2 is a flowchart showing a method of manufacturing the magnetic sensor;
FIG. 3 is a graph showing a characteristic of the magnetic sensor; and
FIG. 4 is a graph showing a characteristic of the magnetic sensor.

### Description of Embodiments

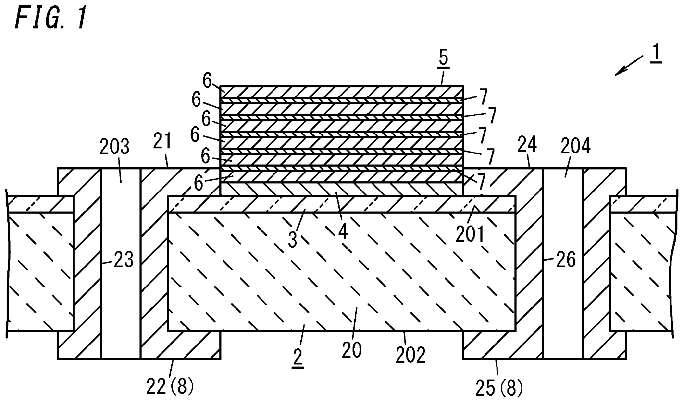

A magnetic sensor and a method of manufacturing the magnetic sensor according to an exemplary embodiment will now be described with reference to the accompanying drawings. Note that the embodiment to be described below is only an exemplary one of various embodiments of the present disclosure and should not be construed as limiting. Rather, the embodiment may be readily modified in various manners depending on a design choice or any other factor without departing from the scope of the present disclosure. The drawings to be referred to in the following description of embodiments are all schematic representations. Thus, the ratio of the dimensions (including thicknesses) of respective constituent elements illustrated on the drawings (e.g., the ratio of the thickness of the conductor 21, 22 to the thickness of the glazing layer 3 shown in FIG. 1) does not always reflect their actual dimensional ratio.

### (Embodiment)

### (Overview)

As shown in FIG. 1, a magnetic sensor 1 according to an exemplary embodiment includes a ceramic substrate 2, a giant magnetoresistive effect (GMR) layer 5, and an undercoat layer 4. The ceramic substrate 2 includes a substrate body 20 and a glazing layer 3. The substrate body 20 contains a ceramic as a material thereof. The glazing layer 3 is formed on a surface of the substrate body 20. The GMR layer 5 has a multilayer structure of a plurality of magnetic layers 6 and a plurality of non-magnetic layers 7. The undercoat layer 4 is formed between the glazing layer 3 and the GMR layer 5. The undercoat layer 4 contains a body-centered cubic (BCC) solid solution.

According to this embodiment, forming the undercoat layer 4 between the glazing layer 3 and the GMR layer 5 reduces the difference in surface energy between the ceramic substrate 2 and the magnetic layers 6 of the GMR layer 5. This promotes the crystal growth of the magnetic layers 6 in a direction parallel to the surface of the substrate body 20 in the step of forming the magnetic layers 6, thus enabling forming magnetic layers 6 to a small thickness. This contributes to increasing the output of the GMR layer 5. In addition, the surface of the glazing layer 3 may be planarized more easily than the surface of the substrate body 20. That is to say, providing the glazing layer 3 allows the surface of the ceramic substrate 2 to be planarized. This further promotes the crystal growth of the magnetic layers 6 in the direction parallel to the surface of the substrate body 20.

### (Details)

Next, a magnetic sensor 1 according to this embodiment will be described in further detail. In the following description, one side on which the GMR layer 5 is provided is supposed to be upside as viewed from the ceramic substrate 2, while the other side on which the ceramic substrate 2 is provided is supposed to be downside as viewed from the GMR layer 5. Note that these definitions should not be construed as limiting the directions in which the magnetic sensor 1 is used.

### (1) Ceramic substrate

The ceramic substrate 2 includes the substrate body 20, the glazing layer 3, and conductors 21-26.

In this embodiment, the ceramic substrate 2 is an alumina substrate. That is to say, the ceramic substrate 2 contains alumina as a material for the substrate body 20. The alumina content (purity) is preferably equal to or greater than 96% and equal to or less than 99%. In other words, the substrate body 20 preferably contains, as its material, alumina having an alumina content equal to or greater than 96% and equal to or less than 99%. This provides a ceramic substrate 2 with high strength.

The substrate body 20 has a first surface 201 and a second surface 202. The first surface 201 is a surface (upper surface) of the substrate body 20 on one side of a thickness direction. The second surface 202 is a surface (lower surface) of the substrate body 20 on the other side of the thickness direction. That is to say, the second surface 202 is a surface opposite from the first surface 201.

The first surface 201 is formed as a planar surface. The glazing layer 3 is formed on the first surface 201.

The second surface 202 is formed as a planar surface. The conductors 22, 25 are arranged on the second surface 202. The conductors 22, 25 are electrically connected to the GMR layer 5. Each of the conductors 22, 25 serves as an electrode 8 for extracting an output signal from the GMR layer 5. That is to say, the ceramic substrate 2 includes a pair of electrodes 8 which are electrically connected to the GMR layer 5.

The substrate body 20 has a plurality of (e.g., two in FIG. 1) through holes 203, 204. Each of these through holes 203, 204 penetrates through the first surface 201 and the second surface 202. These through holes 203, 204 are provided adjacent to the GMR layer 5.

The glazing layer 3 is formed over the entire first surface 201. The glazing layer 3 contains, as its material, a glass material such as amorphous glass.

The conductors 21-26 are made of a conductive material such as silver-palladium (Ag-Pd). The conductors 21, 24 are formed on the surface (upper surface) of the glazing layer 3. The conductors 22, 25 are formed on the second surface 202 of the substrate body 20. The conductor 23 is passed through the through hole 203. In other words, the conductor 23 is formed on an inner surface of the through hole 203. The conductor 26 is passed through the through hole 204. In other words, the conductor 26 is formed on an inner surface of the through hole 204.

The conductors 21-23 are electrically connected to each other. The conductor 21 is in contact with, and thereby electrically connected to, the GMR layer 5. The GMR layer 5 is electrically connected to the conductor 22 (electrode 8) via the conductors 21, 23. In other words, the conductors 21, 23 electrically connect the conductor 22 (electrode 8) to the GMR layer 5.

The conductors 24-26 are electrically connected to each other. The conductor 24 is in contact with, and thereby electrically connected to, the GMR layer 5. The GMR layer 5 is electrically connected to the conductor 25 (electrode 8) via the conductors 24, 26. In other words, the conductors 24, 26 electrically connect the conductor 25 (electrode 8) to the GMR layer 5.

The ceramic substrate 2 is mounted on another substrate. More specifically, the second surface 202 of the substrate body 20 faces a surface of the other substrate. In addition, the conductors 22, 25 (a pair of electrodes 8) are in contact with, and electrically connected to, a conductor formed on the surface of the other substrate.

The glazing layer 3 preferably has a thickness equal to or greater than 10 µm and equal to or less than 100 µm. Also, the surface (upper surface), on which the undercoat layer 4 is formed, of the glazing layer 3 preferably has as small surface roughness as possible. In this case, the surface roughness may be represented by a surface texture parameter such as the arithmetic mean roughness Ra defined by the JIS B 0601 standard. That surface, on which the undercoat layer 4 is formed, of the glazing layer 3 preferably has an arithmetic mean roughness Ra equal to or less than 0.02 µm.

### (2) Undercoat layer

The undercoat layer 4 is formed to cover only a selected area of the surface of the glazing layer 3. The undercoat layer 4 may have, for example, a rectangular shape. The surface (upper surface) of the undercoat layer 4 is formed to have a planar shape. The undercoat layer 4 may have a thickness of about 3-5 nm, for example.

The undercoat layer 4 contains a BCC solid solution. As used herein, the "BCC solid solution" refers to a solid solution having a body-centered cubic structure. The BCC solid solution preferably contains at least one of nickel-iron-chromium (Ni-Fe-Cr) or iron-silicon (Fe-Si). Alternatively, nickel-chromium (Ni-Cr) may also be adopted as a BCC solid solution as a constituent material for the undercoat layer 4.

### (3) GMR layer

The GMR layer 5 is formed over the entire surface (upper surface) of the undercoat layer 4. The GMR layer 5 includes a plurality of magnetic layers 6 and a plurality of non-magnetic layers 7. The magnetic layers 6 and the non-magnetic layers 7 are alternately stacked one on top of another. One of the plurality of magnetic layers 6 is the lowermost layer of the GMR layer 5 (i.e., a layer directly in contact with the undercoat layer 4). The sum of the number of the magnetic layers 6 and the number of the non-magnetic layers 7 may be, for example, equal to or greater than 10, or equal to or greater than 20. When viewed in the direction in which the magnetic layers 6 and the non-magnetic layers 7 are stacked (i.e., upward/downward direction), the plurality of magnetic layers 6 and the plurality of non-magnetic layers 7 preferably have the same dimensions. Alternatively, at least one of the plurality of magnetic layers 6 and the plurality of non-magnetic layers 7 may have different dimensions from the other layers.

The magnetic layers 6 are layers of a ferromagnetic material. The magnetic layers 6 are more easily magnetizable than the non-magnetic layers 7. The magnetic layers 6 may contain, for example, cobalt-iron-nickel (Co-Fe-Ni). The non-magnetic layers 7 are layers of a non-magnetic material. The non-magnetic layers 7 may contain, for example, copper (Cu).

Each of the magnetic layers 6 and the non-magnetic layers 7 may, for example, have a thickness on the order of a few nm. In this embodiment, each of the magnetic layers 6 may have a thickness of about 2 nm. On the other hand, each of the non-magnetic layers 7 may have a thickness of about 1 nm, for example.

The electrical resistance of the GMR layer 5 varies according to the magnitude and orientation of a magnetic field applied. The magnetic field may be detected by measuring the electrical resistance of the GMR layer 5. The pair of electrodes 8 outputs the electrical resistance of the GMR layer 5 as a voltage signal, of which the magnitude corresponds to the electrical resistance.

### (Manufacturing method)

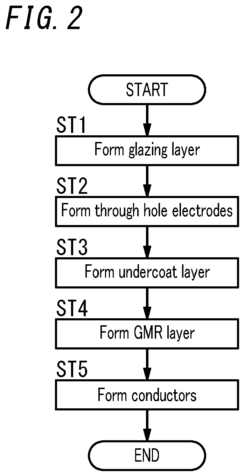

Next, an exemplary method of manufacturing the magnetic sensor 1 will be described with reference to the flowchart shown in FIG. 2.

First, a substrate body 20 is provided. Next, a glazing layer 3 is formed on a first surface 201 of the substrate body 20 (in Step ST1). More specifically, the glazing layer 3 is formed by printing a glass paste onto the first surface 201 and firing the glass paste.

The glass paste contains glass and a filler. As the glass, an SiO₂-B₂O₃-ZnO-R₂O based glass including an alkali metal oxide R₂O or an SiO₂-B₂O₃-R₂O based glass is preferably used. As the filler, an alumina powder is preferably used to make the thermal expansion coefficient of the glazing layer 3 closer to the thermal expansion coefficient of the substrate body 20.

Next, through holes 203, 204 are opened. In addition, conductors 23. 26 are formed inside the through holes 203, 204, respectively (in Step ST2).

Subsequently, an undercoat layer 4 is formed on the surface of the glazing layer 3 (in Step ST3). The undercoat layer 4 may be formed by sputtering, for example.

Thereafter, a GMR layer 5 is formed on the surface of the undercoat layer 4 (in Step ST4). Specifically, magnetic layers 6 and non-magnetic layers 7 are alternately formed on the surface of the undercoat layer 4. The magnetic layers 6 and the non-magnetic layers 7 may be formed by sputtering, for example.

Next, conductors 21, 22, 24, 25 are formed (in Step ST5). Specifically, conductors are printed on the surface of the glazing layer 3 and on the second surface 202 of the substrate body 20.

A magnetic sensor 1 may be manufactured by performing these process steps.

As can be seen from the foregoing description, a method of manufacturing a magnetic sensor 1 according to an aspect includes the steps of: forming a glazing layer 3 on a surface of a substrate body 20 containing a ceramic as a material thereof; forming an undercoat layer 4, containing a BCC solid solution, on a surface of the glazing layer 3; and forming a GMR layer 5, having a multilayer structure of a plurality of magnetic layers 6 and a plurality of non-magnetic layers 7, on a surface of the undercoat layer 4.

### (Advantages)

Next, advantages of the magnetic sensor 1 according to this embodiment will be described.

As described above, in the magnetic sensor 1, forming the undercoat layer 4 promotes the crystal growth of the magnetic layers 6 in the direction parallel to the surface of the substrate body 20, thus enabling forming the magnetic layers 6 to a small thickness. This contributes to increasing the output of the GMR layer 5. In addition, providing the glazing layer 3 allows the surface of the ceramic substrate 2 to be planarized. This further promotes the crystal growth of the magnetic layers 6 in the direction parallel to the surface of the substrate body 20.

In addition, in the magnetic sensor 1 according to this embodiment, the conductors 21, 24 are in contact with lower layers of the GMR layer 5. This eliminates, compared to a situation where a pair of surface electrodes are formed on the upper surface of the GMR layer 5 and need to be electrically connected to the conductors 21, 24 by wire bonding, the need to provide a space for wires, thus cutting down the space occupied by the magnetic sensor 1.

The advantages of the magnetic sensor 1 according to this embodiment will be described with the magnetic sensor 1 compared with a magnetic sensor as a first comparative example. The magnetic sensor according to the first comparative example replaces the ceramic substrate 2 including the glazing layer 3 with a silicon substrate, which is a difference from the magnetic sensor 1 according to this embodiment. Although the silicon substrate includes no glazing layer 3, an insulating layer of thermal oxide is formed instead of the glazing layer 3. That is to say, the silicon substrate of the magnetic sensor 1 according to the first comparative example is a thermal oxide silicon substrate. In the other respects, the magnetic sensor according to the first comparative example has the same configuration as the magnetic sensor 1 according to this embodiment. The difference in surface energy between the thermal oxide silicon substrate and the undercoat layer 4 would be greater than the difference in surface energy between the ceramic substrate 2 including the glazing layer 3 and the undercoat layer 4. Thus, the GMR layer 5 of the magnetic sensor according to the first comparative has a different degree of planarity and a different crystallographic orientation from the counterpart of the magnetic sensor 1 according to this embodiment. Consequently, the GMR layer 5 of the magnetic sensor according to the first comparative example exhibits a different characteristic than the counterpart of the magnetic sensor 1 according to this embodiment.

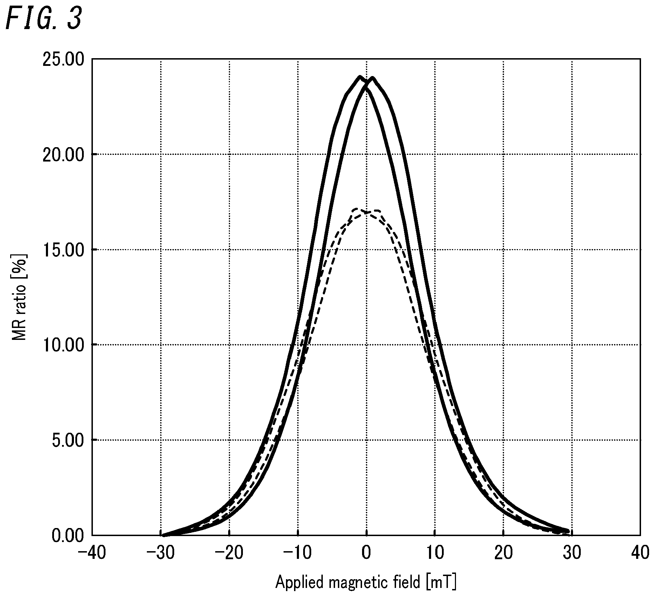

In FIG. 3, the MR ratio of the magnetic sensor 1 according to this embodiment is indicated by the solid curves and the MR ratio of the magnetic sensor according to the first comparative example is indicated by the dotted curves. As used herein, the "MR ratio" refers to the rate of variation in the electrical resistance of a magnetoresistive element upon the application of magnetic field. The magnetic sensor 1 according to this embodiment has a larger MR ratio than the magnetic sensor according to the first comparative example. Specifically, a peak of the MR ratio of the magnetic sensor according to the first comparative example is 17.1%, while a peak of the MR ratio of the magnetic sensor 1 according to this embodiment is 24.0%. As can be seen, the magnetic sensor 1 according to this embodiment causes a significant increase in the MR ratio by using the ceramic substrate 2 including the glazing layer 3.

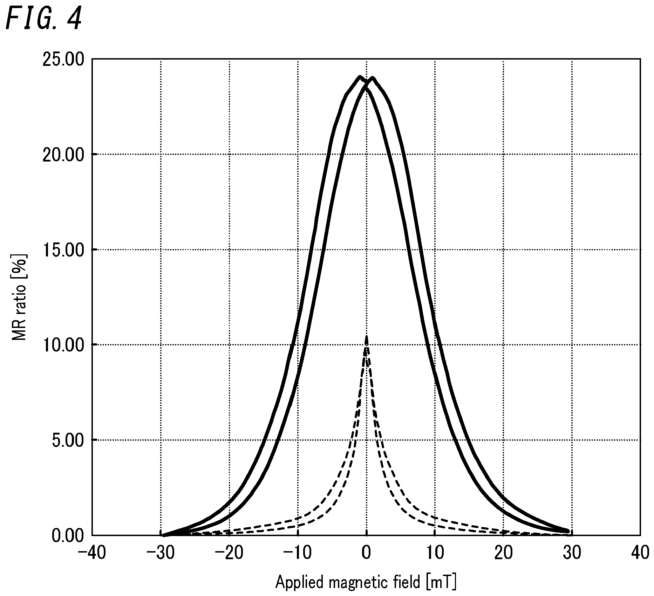

In FIG. 4, the MR ratio of the magnetic sensor 1 according to this embodiment is indicated by the solid curves and the MR ratio of a magnetic sensor according to a second comparative example is indicated by the dotted curves. The magnetic sensor according to the second comparative example includes no undercoat layer 4, which is a difference from the magnetic sensor 1 according to this embodiment. The difference in surface energy between the ceramic substrate 2 and the GMR layer 5 would be greater than the difference in surface energy between the undercoat layer 4 and the GMR layer 5. Thus, the GMR layer 5 of the magnetic sensor according to the second comparative example has a different degree of planarity and a different crystallographic orientation from the counterpart of the magnetic sensor 1 according to this embodiment. Consequently, the GMR layer 5 of the magnetic sensor according to the second comparative example exhibits a different characteristic (MR ratio) than the counterpart of the magnetic sensor 1 according to this embodiment.

The magnetic sensor 1 according to this embodiment has a larger MR ratio than the magnetic sensor according to the second comparative example. Specifically, a peak of the MR ratio of the magnetic sensor according to the second comparative example is 10.7%, while a peak of the MR ratio of the magnetic sensor 1 according to this embodiment is 24.0%. As can be seen, the magnetic sensor 1 according to this embodiment causes a significant increase in the MR ratio by forming the undercoat layer 4 on the surface of the ceramic substrate 2.

### (Variations of exemplary embodiment)

Next, variations of the exemplary embodiment will be enumerated one after another. Note that the variations to be described below may be adopted in combination as appropriate.

The ceramic substrate 2 does not have to be an alumina substrate. Alternatively, the ceramic substrate 2 may also be, for example, an aluminum nitride substrate. That is to say, the substrate body 20 may contain aluminum nitride as a material thereof.

The undercoat layer 4 does not have to be a single layer but may include multiple layers.

The undercoat layer 4 may be formed over the entire surface (upper surface) of the glazing layer 3, instead of being formed in only a selected area of the surface of the glazing layer 3.

The GMR layer 5 does not have to cover the entire surface (upper surface) of the undercoat layer 4 but may be formed in only a selected area of the surface of the undercoat layer 4.

In the foregoing description of embodiments, if one of two values being compared with each other is "equal to or greater than" the other, this phrase may herein cover both a situation where these two values are equal to each other and a situation where one of the two values is greater than the other. However, this should not be construed as limiting. Alternatively, the phrase "equal to or greater than" may also be a synonym of the phrase "greater than" that covers only a situation where one of the two values is over the other. That is to say, it is arbitrarily changeable, depending on selection of a reference value or any preset value, whether the phrase "equal to or greater than" covers the situation where the two values are equal to each other. Therefore, from a technical point of view, there is no difference between the phrase "equal to or greater than" and the phrase "greater than." Similarly, the phrase "equal to or less than" may be a synonym of the phrase "less than" as well.

### (Recapitulation)

The exemplary embodiment and its variations described above are specific implementations of the following aspects of the present disclosure.

A magnetic sensor (1) according to a first aspect includes a ceramic substrate (2), a GMR layer (5), and an undercoat layer (4). The ceramic substrate (2) includes a substrate body (20) and a glazing layer (3). The substrate body (20) contains a ceramic as a material thereof. The glazing layer (3) is formed on a surface of the substrate body (20). The GMR layer (5) has a multilayer structure of a plurality of magnetic layers (6) and a plurality of non-magnetic layers (7). The undercoat layer (4) is formed between the glazing layer (3) and the GMR layer (5). The undercoat layer (4) contains a BCC solid solution.

According to this configuration, forming the undercoat layer (4) between the glazing layer (3) and the GMR layer (5) reduces the difference in surface energy between the ceramic substrate (2) and the magnetic layers (6) of the GMR layer (5). This promotes the crystal growth of the magnetic layers (6) in a direction parallel to the surface of the substrate body (20) in the step of forming the magnetic layers (6), thus enabling forming magnetic layers (6) to a small thickness. This contributes to increasing the output of the GMR layer (5). In addition, the surface of the glazing layer (3) may be planarized more easily than the surface of the substrate body (20). Providing the glazing layer (3) allows the surface of the ceramic substrate (2) to be planarized, thus further promoting the crystal growth of the magnetic layers (6) in the direction parallel to the surface of the substrate body (20).

In a magnetic sensor (1) according to a second aspect, which may be implemented in conjunction with the first aspect, the substrate body (20) contains, as a material thereof, alumina having an alumina content equal to or greater than 96% and equal to or less than 99%.

This configuration allows the use of a ceramic substrate (2) with high strength.

In a magnetic sensor (1) according to a third aspect, which may be implemented in conjunction with the first aspect, the ceramic substrate (2) is an aluminum nitride substrate.

This configuration allows the uses of a ceramic substrate (2) with high strength.

In a magnetic sensor (1) according to a fourth aspect, which may be implemented in conjunction with any one of the first to third aspects, the BCC solid solution contains at least one of Ni-Fe-Cr or Fe-Si.

This configuration reduces the difference in surface energy between the ceramic substrate (2) and the magnetic layers (6) of the GMR layer (5).

In a magnetic sensor (1) according to a fifth aspect, which may be implemented in conjunction with any one of the first to fourth aspects, the ceramic substrate (2) further includes an electrode (conductors 22, 25) electrically connected to the GMR layer (5) and a conductor (21, 23, 24, 26) electrically connected to the electrode. The substrate body (20) has a first surface (201) on which the glazing layer (3) is formed and a second surface (202) which is opposite from the first surface (201) and on which the electrode is disposed. The substrate body (20) further has a through hole (203, 204) penetrating through the first surface (201) and the second surface (202). The conductor (23, 26) is passed through the through hole (203, 204) to electrically connect the electrode and the GMR layer (5) to each other.

According to this configuration, the electrode is disposed on the second surface (202) of the ceramic substrate (2), thus making it easier to electrically connect the electrode to another substrate facing the second surface (202). In addition, using a ceramic substrate (2) with a relatively high strength as the substrate reduces the chances of the strength of the ceramic substrate (2) being less than a required strength even when the through hole (203, 204) is opened through the ceramic substrate (2).

In a magnetic sensor (1) according to a sixth aspect, which may be implemented in conjunction with any one of the first to fifth aspects, the glazing layer (3) has a thickness equal to or greater than 10 µm and equal to or less than 100 µm.

According to this configuration, the glazing layer (3) may be thick enough to have its surface planarized easily.

In a magnetic sensor (1) according to a seventh aspect, which may be implemented in conjunction with any one of the first to sixth aspects, a surface, on which the undercoat layer (4) is formed, of the glazing layer (3) has an arithmetic mean roughness equal to or less than 0.02 µm.

According to this configuration, the glazing layer (3) has a relatively small surface roughness. That is to say, the glazing layer (3) has a planarized surface, thus promoting the crystal growth of the magnetic layers (6) in a direction parallel to the surface of the ceramic substrate (2).

Note that the constituent elements according to the second to seventh aspects are not essential constituent elements for the magnetic sensor (1) but may be omitted as appropriate.

A method of manufacturing a magnetic sensor (1) according to an eighth aspect includes the steps of: forming a glazing layer (3) on a surface of a substrate body (20) containing a ceramic as a material thereof; forming an undercoat layer (4), containing a BCC solid solution, on a surface of the glazing layer (3); and forming a GMR layer (5), having a multilayer structure of a plurality of magnetic layers (6) and a plurality of non-magnetic layers (7), on a surface of the undercoat layer (4).

This method contributes to increasing the output of the GMR layer (5).

Note that these are not the only aspects of the present disclosure but various configurations (including variations) of the magnetic sensor (1) according to the exemplary embodiment described above may also be implemented as, for example, a method of manufacturing a magnetic sensor (1).

### Reference Signs List

- 1: Magnetic Sensor
- 2: Ceramic Substrate
- 3: Glazing Layer
- 4: Undercoat Layer
- 5: GMR Layer
- 6: Magnetic Layer
- 7: Non-Magnetic Layer
- 20: Substrate Body
- 22, 25: Conductor (Electrode)
- 21, 23, 24, 26: Conductor
- 201: First Surface
- 202: Second Surface
- 203, 204: Through Hole

## Claims

1. A magnetic sensor comprising:
a ceramic substrate including: a substrate body containing a ceramic as a material thereof; and a glazing layer formed on a surface of the substrate body;
a giant magnetoresistive effect layer having a multilayer structure of a plurality of magnetic layers and a plurality of non-magnetic layers; and
an undercoat layer formed between the glazing layer and the giant magnetoresistive effect layer and containing a body-centered cubic solid solution.

2. The magnetic sensor of claim 1, wherein
the substrate body contains, as a material thereof, alumina having an alumina content equal to or greater than 96% and equal to or less than 99%.

3. The magnetic sensor of claim 1, wherein
the ceramic substrate is an aluminum nitride substrate.

4. The magnetic sensor of any one of claims 1 to 3, wherein
the body-centered cubic solid solution contains at least one of Ni-Fe-Cr or Fe-Si.

5. The magnetic sensor of any one of claims 1 to 4, wherein
the ceramic substrate further includes: an electrode electrically connected to the giant magnetoresistive effect layer; and a conductor electrically connected to the electrode,
the substrate body has: a first surface on which the glazing layer is formed; a second surface which is opposite from the first surface and on which the electrode is disposed; and a through hole penetrating through the first surface and the second surface, and
the conductor is passed through the through hole to electrically connect the electrode and the giant magnetoresistive effect layer to each other.

6. The magnetic sensor of any one of claims 1 to 5, wherein
the glazing layer has a thickness equal to or greater than 10 µm and equal to or less than 100 µm.

7. The magnetic sensor of any one of claims 1 to 6, wherein
a surface, on which the undercoat layer is formed, of the glazing layer has an arithmetic mean roughness equal to or less than 0.02 µm.

8. A method of manufacturing a magnetic sensor, the method comprising the steps of:
forming a glazing layer on a surface of a substrate body containing a ceramic as a material thereof;
forming an undercoat layer, containing a body-centered cubic solid solution, on a surface of the glazing layer; and
forming a giant magnetoresistive effect layer, having a multilayer structure of a plurality of magnetic layers and a plurality of non-magnetic layers, on a surface of the undercoat layer.
